(19) Europäisches Patentamt / European Patent Office / Office européen des brevets

(11) **EP 4 597 132 A1**

(12) **EUROPEAN PATENT APPLICATION**

(43) Date of publication:
06.08.2025 Bulletin 2025/32

(21) Application number: 25150666.3

(22) Date of filing: 08.01.2025

(51) International Patent Classification (IPC):
**G01R 31/34** (2020.01)      G01R 31/42 (2006.01)

(52) Cooperative Patent Classification (CPC):
**G01R 31/346; G01R 31/343; H02P 29/024;**
G01R 31/42

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.01.2024 GB 202400994**

(71) Applicant: **Rolls-Royce plc**
**London N1 9FX (GB)**

(72) Inventors:
• **Nadarajan, Sivakumar**
**Derby, DE24 8BJ (GB)**
• **Vaiyapuri, Viswanathan**
**Derby, DE24 8BJ (GB)**
• **Mohamed Halick, Mohamed Sathik**
**Derby, DE24 8BJ (GB)**
• **Kumar, Logesh**
**Derby, DE24 8BJ (GB)**

(74) Representative: **Rolls-Royce plc**
**Moor Lane (ML-9)**
**PO Box 31**
**Derby DE24 8BJ (GB)**

(54) **MULTIPHASE ELECTRICAL MACHINE CONDITION MONITORING**

(57)      The disclosure relates to monitoring of multiphase electrical machines, in particular to determine the presence or absence of a winding fault. A method of monitoring first and second multiphase electrical machines ($101_1$, $101_2$) driven by respective first and second power electronics modules ($102_1$, $102_2$) from respective first and second DC electrical supplies ($103_1$, $103_2$) comprises: measuring first and second DC link currents (Idc1, Idc2) from the respective first and second DC electrical supplies ($103_1$, $103_2$) to the respective first and second power electronics modules ($102_1$, $102_2$); measuring stator currents (Ia1, Ib1, Ia2, Ib2) through phases of the first and second electrical machines ($101_1$, $101_2$); calculating a first ratio from a harmonic component of the first DC link current (Idc1) divided by a harmonic component of the second DC link current (Idc2); calculating a second ratio from a harmonic component of a positive sequence stator current through the first electrical machine ($101_1$) divided by a harmonic component of a positive sequence stator current through the second electrical machine ($101_2$); calculating a third ratio from a DC component of a combined sequence stator current through the first electrical machine ($101_1$) divided by a DC component of a combined sequence stator current through the second electrical machine ($101_2$); and determining a winding fault in the first or second electrical machine ($101_1$, $101_2$) if one or more of the first, second and third ratios is outside of a predetermined range.

*FIG. 1*

**Description**

**TECHNICAL FIELD**

The disclosure relates to monitoring of multiphase electrical machines, in particular to determine the presence or absence of a winding fault.

**BACKGROUND**

Over recent years, many countries have committed to cut carbon emissions in the coming decades due to environmental concerns. International aviation is included in some of these targets. The electrification of aviation is a potential solution for reducing emissions, enabling the way towards more sustainable aviation. Advantages of electrification can include higher efficiency, lower maintenance requirements, fuel savings and extended control. In so-called 'more electric' aircraft, mechanical, pneumatic and hydraulic subsystems of conventional aircrafts are over time being replaced with electrical counterparts. There is also a growing trend towards all-electric propulsion for small commuter aircraft and hybrid propulsion for larger aircraft.

Urban air mobility (UAM) applications such as air taxis and electric take-off and landing (eVTOL) aircraft may use high-power density permanent magnet electrical machines for power and propulsion. Multiphase electrical machines, typically three-phase electrical machines, can play a key role in these applications for fault tolerant operation. The winding insulation in such machines, which is subjected to high electrical and thermal stresses, may degrade gradually, leading to turn-to-turn short circuit (TTSC) or inter-turn short circuit (ITSC) in the incipient stage. This causes the flow of high short circuit loop currents, which creates local hot-spots and leads to further insulation degradation of the neighboring windings. Turn-to-turn short circuits can lead to winding degradation. When undetected in the early stage, this can lead to catastrophic phase-to-phase short circuits and phase-to-ground short circuits. Hence, there is a need to develop suitable and accurate methods for detecting such kinds of winding failures before they lead to winding degradation.

Power electronics converters are key components in the power and propulsion systems of UAM and eVTOL aircraft. A power electronics converter comprises components including power devices, capacitors, PCBs, and a cooling system. The power devices and capacitors tend to be weak links in any power converter system. Failures in such components can be mainly due to environmental and electrical stresses, which cause periodic wear that may eventually lead to component failures. These failures can be prevented by employing a suitable condition monitoring system to identify and predict component degradation to estimate the remaining useful life.

It is estimated that, in failures of power electronic converters, the capacitors and the power modules can contribute to around 50% of total failures. The failure of a power converter can lead to failure of an entire system or at least severe performance degradation that can make the system unusable. Despite extensive efforts by manufacturers to improve the reliability of power electronic components such as power modules, capacitors and implementation of cautious and conservative design methodologies, power module and capacitor failures can still occur due to wear caused by long term effects of electrical and environmental stress factors. These failures are accelerated in demanding applications such as those in aerospace and defence sectors and can lead to the shutdown of a whole electrical system. Therefore, condition or health monitoring systems capable of tracking the current health status of a power converter and, if necessary, performing failure prognosis is important for critical applications.

Current proposed solutions for condition monitoring of power converters tend to be aimed at identifying individual component failures rather than to provide a solution for an overall power converter.

**SUMMARY**

According to a first aspect there is provided a method of monitoring first and second multiphase electrical machines driven by respective first and second power electronics modules from respective first and second DC electrical supplies, the method comprising:

measuring first and second DC link currents from the respective first and second DC electrical supplies to the respective first and second power electronics modules;
measuring stator currents through phases of the first and second electrical machines;
calculating a first ratio from a harmonic component of the first DC link current divided by a harmonic component of the second DC link current;
calculating a second ratio from a harmonic component of a positive sequence stator current through the first electrical machine divided by a harmonic component of a positive sequence stator current through the second electrical machine;
calculating a third ratio from a DC component of a combined sequence stator current through the first electrical machine divided by a DC component of a combined sequence stator current through the second electrical machine; and

determining a winding fault in the first or second electrical machine if one or more of the first, second and third ratios is outside of a predetermined range.

The harmonic component of the first and second DC link currents may be a second harmonic component.

The harmonic component of the positive sequence stator current through the first and second electrical machines may be a third harmonic component.

The positive sequence stator current for each electrical machine may be calculated as

$$\frac{1}{3}(I_a + a * I_b + a^2 * I_c)$$

, where $I_a$, $I_b$, $I_c$ are the stator currents through the electrical machine and

$$a = -0.5 + j\frac{\sqrt{3}}{2}$$

The combined sequence stator current for each electrical machine may be calculated as

$$I_a^2 + I_b * I_c + I_c * I_b$$, where $I_a$, $I_b$, $I_c$ are the stator currents through the electrical machine.

The winding fault may be determined to be in the first electrical machine if one or more of the first, second and third ratios is above the predetermined range.

The winding fault may be determined to be in the second electrical machine if one or more of the first, second and third ratios is below the predetermined range.

The predetermined range may be within 1 to 5% of 1.

The predetermined range may be between around 0.98 and around 1.02.

The winding fault may be a turn-to-turn short circuit.

The winding fault may be determined if the one or more of the first, second and third ratios is outside of the predetermined range for longer than a predetermined time period. The predetermined time period may be 10 seconds, 30 seconds or 1 minute.

The winding fault may be determined if any two of the ratios are outside of the predetermined range.

According to a second aspect there is provided a power electronics system comprising:

first and second electrical machines each comprising a plurality of stator phases;
first and second inverters configured to receive a respective first and second DC link current from respective first and second DC supplies and provide AC currents to the plurality of stator phases of the respective first and second electrical machines;
a condition monitoring unit configured to:

measure first and second DC link currents from the respective first and second DC electrical supplies to the respective first and second power electronics modules;
measure stator currents through phases of the first and second electrical machines;
calculate a first ratio from a harmonic component of the first DC link current divided by a harmonic component of the second DC link current;
calculate a second ratio from a harmonic component of a positive sequence stator current through the first electrical machine divided by a harmonic component of a positive sequence stator current through the second electrical machine;
calculate a third ratio from a DC component of a combined sequence stator current through the first electrical machine divided by a DC component of a combined sequence stator current through the second electrical machine; and
determine a winding fault in the first or second electrical machine if one or more of the first, second and third ratios is outside of a predetermined range.

The harmonic component of the first and second DC link currents may be a second harmonic component.

The harmonic component of the positive sequence stator current through the first and second electrical machines may be a third harmonic component.

The condition monitoring unit may be configured to calculate a positive sequence stator current for each electrical machine as $\frac{1}{3}(I_a + a *$ $I_b + a^2 * I_c)$, where $I_a$, $I_b$, $I_c$ are the stator currents through the electrical machine and

$$a = -0.5 + j\frac{\sqrt{3}}{2}$$

The condition monitoring unit may be configured to calculate a combined sequence stator current for each electrical machine as $I_a^2 + I_b * I_c + I_c * I_b$, where $I_a$, $I_b$, $I_c$ are the stator currents through the electrical machine.

The condition monitoring unit may be configured to determine a winding fault in the first electrical machine if one or more of the first, second and third ratios is above the predetermined range.

The condition monitoring unit may be configured to determine a winding fault in the second electrical machine if one or more of the first, second and third ratios is below the predetermined range.

The predetermined range may be within 1 to 5% of 1.

The predetermined range may be between around 0.98 and around 1.02.

The winding fault may be a turn-to-turn short circuit.

The condition monitoring unit may be configured to determine the winding fault if the one or more of the first, second and third ratios is outside of the predetermined range for longer than a predetermined time period. The predetermined time period may be 10 seconds, 30 seconds or 1 minute.

The condition monitoring unit may be configured to determine the winding fault if any two of the ratios are outside of the predetermined range.

According to a third aspect there is provided a computer program comprising instructions that, when executed, cause a computer to perform the method according to the first aspect. The computer program may be stored on a non-transitory computer-readable medium.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

## BRIEF DESCRIPTION OF THE DRAWINGS

Embodiments will now be described by way of example only with reference to the accompanying drawings, which are purely schematic and not to scale, and in which:

**Figure 1** is a schematic diagram of an example multi-lane system with electrical machine condition monitoring; and
**Figure 2** is a flow diagram of an example method of determining the presence or absence of a winding fault in a multi-lane system.

## DETAILED DESCRIPTION

The method and system described herein provides a monitoring solution for multi-lane power converters that include power devices, i.e. high power semiconductor switching elements, and capacitors. Simple and accurate fault detection techniques are described for multiphase electrical machines, i.e. electric motors or generators, that enable measurement and extraction of fault signatures to enable detection of a winding fault, for example due to a TTSC. A requirement is that there are at least two multi-phase machines and that the multi-phase machines are electrically and magnetically isolated. There are various benefits of the proposed methods for winding fault detection, including: i) additional sensors not being required; ii) historical data not being required; iii) fixed threshold parameters not being required; iv) the methods being applicable to all winding types, provided they are electrically and magnetically isolated; v) the proposed methods working for multiple-three phase electrical machines; and vi) the proposed methods being computationally simple.

Various techniques are known for detection of turn-to-turn short circuit (TTSC) or inter-turn short circuit (ITSC) faults in multi-lane and multi-phase electrical machines. In general, existing methods use signal-based detection using time or frequency-domain analysis to detect a winding fault. Such methods use historical data to fix a threshold value for winding fault detection. As a result, large amounts of data at different operating conditions are required to allow a threshold to be determined. By contrast, the proposed method described herein uses the measured value from one of the lanes in a multiphase system as a threshold, thereby substantially reducing the computational effort required.

Existing winding fault detection methods for multiphase electrical machines tend to focus on complex and redundant mechanisms to detect and isolate a fault. Data-based fault detection methods, for example using machine learning and deep learning, require large volumes of fault data from different test cases to train and establish a function to detect a fault online. Similarly, signal-based methods suffer from the problem of defining a fault threshold for predictive maintenance. The fault threshold may vary based on different winding configurations and external drive disturbances. Inaccuracy of state estimation and observer method-based fault detection is a major drawback. This is mainly due to the noise in measurement and external factors contributing directly to the inefficiency in tracking the required state parameters. Model-based methods require a reduced-order model running in parallel with the system. The prediction accuracy of such methods is subjected to variation based on the fidelity of the analytical model used. Similarly, the control-based method requires high-frequency signal injection for fault detection, which is mostly carried out at lower power rating, which requires halting operation of the machine. Existing winding fault detection methods therefore tend to suffer either from large computational data requirements or from inaccuracy related to observer tracking or setting of a fault threshold or operational constraints.

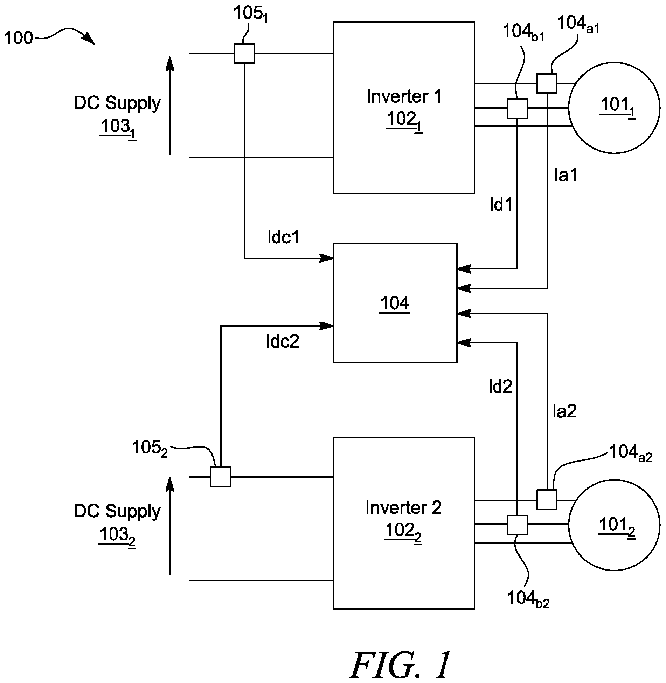

Figure 1 illustrates an example system 100 for monitoring and detecting a winding fault in first and second electrical machines $101_1$, $101_2$. The first and second electrical machines $101_1$, $101_2$ may be separate machines or may be electrical machines with a common stator. Each of the electrical machines $101_1$, $101_2$ comprises a plurality of phases, in this example three phases. The electrical machines $101_1$, $101_2$ are magnetically and electrically isolated from each other, which allows the machines to be monitored in comparison to each other. Each of the electrical machines $101_1$, $101_2$ may operate as a motor or as a generator.

When operating as a motor, each of the three phase windings in the electrical machines $101_1$, $101_2$ is driven by a respective inverter $102_1$, $102_2$, each inverter being powered by a respective DC power supply $103_1$, $103_2$, which may be referred to as a lane in a multi-lane system. In a multiphase machine, the set of three phase windings can be phase shifted electrically by zero degrees or -180 degrees.

A health or condition monitoring unit 104 receives AC stator current measurements signals Ia1, Ib1, Ia2, Ib2 from stator current sensors $104_{a1}$, $104_{b1}$, $104_{a2}$, $104_{b2}$ connected to sense current flowing through the windings of the first and second electrical machines $101_1$, $101_2$ and receives DC link current measurement signals Idc1, Idc2 from DC link current sensors $105_1$, $105_2$ connected to sense current flowing from the first and second DC power supplies $103_1$, $103_2$. Currents through each of the stator phases may be measured, although may need to be measured in only some of the phases. In a three phase electrical machine, the current in only two of the phases needs to be measured, since the current in the third phase can be deduced from the other two currents. For the three currents Ia1, Ib1, Ic1 flowing through the windings of the first machine $101_1$, the current through phase c can be extracted using the relationship Ia1+Ib1+Ic1=0, i.e. Ic1=-Ia1-Ib1.

Based on these measurements of current supplied to the inverters $102_1$, $102_2$ and through each of the stator phases in each of the electrical machines $101_1$, $101_2$, the condition monitoring unit 104 performs calculations and determines whether a winding fault is present in the first or second electrical machine $101_1$, $101_2$.

The condition monitoring unit 104 may be a separate component to the inverters $102_1$, $102_2$ or, in some arrangements, may be provided as part of one or other of the inverters $102_1$, $102_2$. The condition monitoring unit 104 may be implemented using general purpose computer hardware, i.e. with an input/output module for receiving current measurements from current sensors and for providing outputs indicating the condition of the system 100, a processing module for carrying out calculations and a memory module for storing data. The method of monitoring the electrical machines $101_1$, $101_2$ may therefore be described as a computer-implemented method and may be embodied by instructions for causing a computer to perform the method.

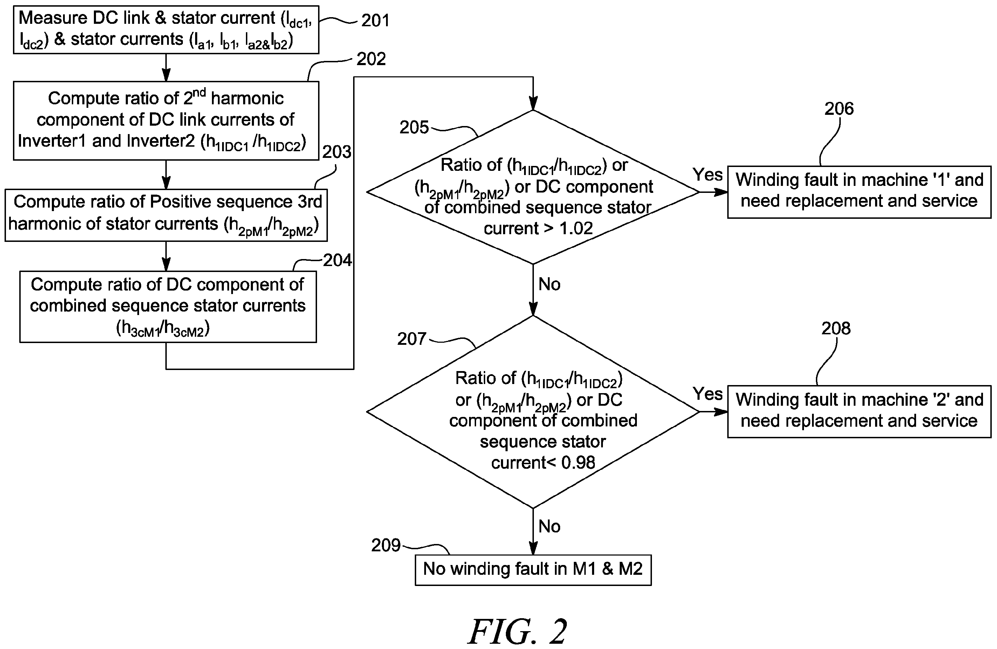

Figure 2 illustrates a proposed winding fault diagnosis algorithm performed by the condition monitoring unit 104 in the form of a flow diagram. The algorithm uses various available sensor parameters including stator currents and DC-link currents from each lane, as defined above, to carry out winding fault diagnosis. The stator current and DC link current sensors required for this do not need to be new sensors but can be sensors that are primarily installed to control the speed and torque of each of the electrical machines $101_1$, $101_2$.

The proposed method first acquires the electrical machine sensor data in step 201, including the stator currents of the electrical machines $101_1$, $101_2$ represented here as $I_{a1}$, $I_{b1}$, $I_{a2}$, and $I_{b2}$. As described above, the stator currents may all be measured directly using current sensors or one of the stator currents may be measured indirectly based on the other directly measured stator currents. The steady state DC-link currents for each machine are also measured, represented as $I_{dc1}$, and $I_{dc2}$. Three different signal-based frequency domain analyses are then carried out. In step 202, the time series DC-link currents are converted to the frequency domain, for example using an FFT (Fast Fourier Transform), and the 2nd harmonic components determined. These harmonic components, represented as $h_{1IDC1}$ and $h_{1IDC2}$ for the first and second machines $101_1$, $101_2$ respectively, are indicators of winding degradation. A first ratio is then determined by dividing $h_{1IDC1}$ by $h_{1IDC2}$.

Secondly, at step 203 the 3rd harmonic positive sequence stator current is determined, represented here as $h_{2pM1}$, and $h_{2pM2}$. The 3rd harmonic positive sequence stator current is a fault indicator for both machines. A second ratio is then determined by dividing $h_{2pM1}$, by $h_{2pM2}$.

The following equation defines a calculation that may be used to determine the positive sequence current $h_{2p}$ for each electrical machine:

$$h_{2p} = \frac{1}{3}(I_a + a * I_b + a^2 * I_c) \qquad (1)$$

$$a = -0.5 + j\frac{\sqrt{3}}{2}$$ where and $$a^2 = -0.5 - j\frac{\sqrt{3}}{2}$$.

At step 204, the DC component of the combined sequence current $h_{3c}$ for each machine is calculated, represented as $h_{3cM1}$ and $h_{3cM2}$ for the first and second electrical machines respectively. A third ratio is calculated by dividing $h_{3cM1}$ by $h_{3cM2}$. The combined sequence current $h_{3c}$ for each electrical machine may be calculated according to the following equation:

$$h_{3c} = i_a^2 + i_b * i_c + i_c * i_b \tag{2}$$

The above steps 202, 203, 204 may be performed in any order or may be carried out in parallel.

During normal operation, the first, second and third ratios should all be close to 1, indicating that the first and second electrical machines are operating nominally relative to each other. A deviation away from 1 will tend to indicate that one of the electrical machines has a winding fault. The direction of deviation will indicate which of the two electrical machines has a winding fault.

If, at step 205, any one or more of the first, second or third ratios is above a predetermined range, for example above 1.02, and optionally for a specific period of time, then it can be concluded that degradation has occurred in the first electrical machine $101_1$, which needs replacement or service (step 206). Similarly, at step 207, if any one or more of the first, second or third ratios is below the predetermined range, for example below 0.98, and optionally for a specific period of time, then it can be concluded that a winding fault has occurred in the second electrical machine $101_2$, which needs replacement or service. If the ratios are all within the predetermined range, for example equal or within around $\pm1\%$, $\pm2\%$ or $\pm5\%$ of 1, it can be inferred that the electrical machines are healthy and no winding fault has occurred.

To avoid triggering a winding fault from momentary fluctuations in one or more of the ratios, for example due to noise, a winding fault may be determined if one or more of the ratios is outside of the predetermined range for a predetermined time period, which may for example be greater than 10 seconds, 30 seconds or 1 minute.

To further ensure the accuracy of a winding fault detection, a winding fault may be determined if any two of the ratios are outside of a predetermined range. The predetermined range may be the same for each of the ratios or may be different for each of the ratios.

**Claims**

1. A method of monitoring first and second multiphase electrical machines ($101_1$, $101_2$) driven by respective first and second power electronics modules ($102_1$, $102_2$) from respective first and second DC electrical supplies ($103_1$, $103_2$), the method comprising:

   measuring first and second DC link currents (Idc1, Idc2) from the respective first and second DC electrical supplies ($103_1$, $103_2$) to the respective first and second power electronics modules ($102_1$, $102_2$);
   measuring stator currents (Ia1, Ib1, Ia2, Ib2) through phases of the first and second electrical machines ($101_1$, $101_2$);
   calculating a first ratio from a harmonic component of the first DC link current (Idc1) divided by a harmonic component of the second DC link current (Idc2);
   calculating a second ratio from a harmonic component of a positive sequence stator current through the first electrical machine ($101_1$) divided by a harmonic component of a positive sequence stator current through the second electrical machine ($101_2$);
   calculating a third ratio from a DC component of a combined sequence stator current through the first electrical machine ($101_1$) divided by a DC component of a combined sequence stator current through the second electrical machine ($101_2$); and
   determining a winding fault in the first or second electrical machine ($101_1$, $101_2$) if one or more of the first, second and third ratios is outside of a predetermined range.

2. The method of claim 1, wherein the harmonic component of the first and second DC link currents (Idc1, Idc2) is a second harmonic component.

3. The method of claim 1 or claim 2, wherein the harmonic component of the positive sequence stator current through the first and second electrical machines ($101_1$, $101_2$) is a third harmonic component.

4. The method of any preceding claim, wherein the positive sequence stator current for each electrical machine is calculated as $\frac{1}{3}(I_a + a * I_b + a^2 * I_c)$, where $I_a$, $I_b$, $I_c$ are the stator currents through the electrical machine and $a = -0.5 + j\frac{\sqrt{3}}{2}$.

5. The method of any preceding claim, wherein the combined sequence stator current for each electrical machine is calculated as $I_a^2 + I_b * I_c + I_c * I_b$, where $I_a$, $I_b$, $I_c$ are the stator currents through the electrical machine.

6. The method of any preceding claim, wherein the winding fault is determined to be in the first electrical machine ($101_1$) if one or more of the first, second and third ratios is above the predetermined range.

7. The method of any one of claims 1 to 5, wherein the winding fault is determined to be in the second electrical machine ($101_2$) if one or more of the first, second and third ratios is below the predetermined range.

8. A power electronics system (100) comprising:

   first and second electrical machines ($101_1$, $101_2$) each comprising a plurality of stator phases;
   first and second inverters ($102_1$, $102_2$) configured to receive a respective first and second DC link current (Idc1, Idc2) from respective first and second DC supplies ($103_1$, $103_2$) and provide AC currents (Ia1, Ib1, Ia2, Ib2) to the plurality of stator phases of the respective first and second electrical machines ($101_1$, $101_2$);
   a condition monitoring unit (104) configured to:

   measure first and second DC link currents (Idc1, Idc2) from the respective first and second DC electrical supplies ($103_1$, $103_2$) to the respective first and second power electronics modules ($102_1$, $102_2$);
   measure stator currents (Ia1, Ib1, Ia2, Ib2) through phases of the first and second electrical machines ($101_1$, $101_2$);
   calculate a first ratio from a harmonic component of the first DC link current (Idc1) divided by a harmonic component of the second DC link current (Idc2);
   calculate a second ratio from a harmonic component of a positive sequence stator current through the first electrical machine ($101_1$) divided by a harmonic component of a positive sequence stator current through the second electrical machine ($101_2$);
   calculate a third ratio from a DC component of a combined sequence stator current through the first electrical machine ($101_1$) divided by a DC component of a combined sequence stator current through the second electrical machine ($101_2$); and
   determine a winding fault in the first or second electrical machine ($101_1$, $101_2$) if one or more of the first, second and third ratios is outside of a predetermined range.

9. The system (100) of claim 8, wherein the harmonic component of the first and second DC link currents (Idc1, Idc2) is a second harmonic component.

10. The system (100) of claim 8 or claim 9, wherein the harmonic component of the positive sequence stator current through the first and second electrical machines ($101_1$, $101_2$) is a third harmonic component.

11. The system (100) of any one of claims 8 to 10, wherein the condition monitoring unit (104) is configured to calculate a positive sequence stator current for each electrical machine as $\frac{1}{3}(I_a + a * I_b + a^2 * I_c)$, where $I_a$, $I_b$, $I_c$ are the stator currents through the electrical machine and $a = -0.5 + j\frac{\sqrt{3}}{2}$.

12. The system (100) of any one of claims 8 to 11, wherein the condition monitoring unit (104) is configured to calculate a combined sequence stator current for each electrical machine as $I_a^2 + I_b * I_c + I_c * I_b$, where $I_a$, $I_b$, $I_c$ are the stator currents through the electrical machine.

13. The system (100) of any one of claims 8 to 12, wherein the condition monitoring unit is configured to determine a winding fault in the first electrical machine ($101_1$) if one or more of the first, second and third ratios is above the predetermined range.

14. The system (100) of any one of claims 8 to 13, wherein the condition monitoring unit (104) is configured to determine a winding fault in the second electrical machine ($101_2$) if one or more of the first, second and third ratios is below the predetermined range.

15. The system (100) of any one of claims 8 to 14, wherein condition monitoring unit (104) is configured to determine the winding fault if any two of the ratios are outside of the predetermined range.

*FIG. 1*

EP 4 597 132 A1

FIG. 2

Europäisches
Patentamt

European
Patent Office

Office européen
des brevets

## EUROPEAN SEARCH REPORT

**Application Number**

EP 25 15 0666

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2009/195205 A1 (IDE YUJI [JP]) 6 August 2009 (2009-08-06) * claim 1; figures 2,3 * ----- | 1-15 | INV. G01R31/34 ADD. G01R31/42 |
| A | CA 3 129 793 A1 (BOEING CO [US]) 20 March 2022 (2022-03-20) * abstract; figures 6,7 * ----- | 1-15 | |
| A | TW 201 409 055 A (SANYO ELECTRIC CO [JP]) 1 March 2014 (2014-03-01) * the whole document * ----- | 1-15 | |
| A | EP 3 905 466 A1 (BOEING CO [US]) 3 November 2021 (2021-11-03) * paragraph [0060]; figure 5 * ----- | 1-15 | |

**TECHNICAL FIELDS SEARCHED (IPC)**

G01R

The present search report has been drawn up for all claims

| Place of search | Date of completion of the search | Examiner |
|---|---|---|
| Munich | 10 June 2025 | Hijazi, Ali |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 0666

This annex lists the patent family members relating to the patent documents cited in the above-mentioned European search report.
The members are as contained in the European Patent Office EDP file on
The European Patent Office is in no way liable for these particulars which are merely given for the purpose of information.

10-06-2025

| Patent document cited in search report | Publication date | Patent family member(s) | Publication date |
|---|---|---|---|
| US 2009195205 A1 | 06-08-2009 | CN 101499773 A | 05-08-2009 |
| | | JP 5065192 B2 | 31-10-2012 |
| | | JP 2009204600 A | 10-09-2009 |
| | | KR 20090084687 A | 05-08-2009 |
| | | US 2009195205 A1 | 06-08-2009 |
| CA 3129793 A1 | 20-03-2022 | CA 3129793 A1 | 20-03-2022 |
| | | CN 114257156 A | 29-03-2022 |
| | | EP 3972114 A1 | 23-03-2022 |
| | | JP 2022051690 A | 01-04-2022 |
| | | KR 20220038573 A | 29-03-2022 |
| | | US 2022094297 A1 | 24-03-2022 |
| TW 201409055 A | 01-03-2014 | CN 103580555 A | 12-02-2014 |
| | | JP 5442078 B2 | 12-03-2014 |
| | | JP 2014033528 A | 20-02-2014 |
| | | KR 20140018141 A | 12-02-2014 |
| | | TW 201409055 A | 01-03-2014 |
| EP 3905466 A1 | 03-11-2021 | CN 113572380 A | 29-10-2021 |
| | | EP 3905466 A1 | 03-11-2021 |
| | | JP 2021172335 A | 01-11-2021 |
| | | KR 20210134234 A | 09-11-2021 |
| | | TW 202211610 A | 16-03-2022 |
| | | US 11128251 B1 | 21-09-2021 |

EPO FORM P0459

For more details about this annex : see Official Journal of the European Patent Office, No. 12/82